(19) Europäisches Patentamt

European Patent Office

Office européen des brevets

(11) **EP 1 098 370 A2**

(12) **EUROPÄISCHE PATENTANMELDUNG**

(43) Veröffentlichungstag:
**09.05.2001 Patentblatt 2001/19**

(51) Int. Cl.⁷: **H01L 27/108**, H01L 21/8242

(21) Anmeldenummer: **00121868.4**

(22) Anmeldetag: **06.10.2000**

(84) Benannte Vertragsstaaten:
**AT BE CH CY DE DK ES FI FR GB GR IE IT LI LU MC NL PT SE**
Benannte Erstreckungsstaaten:
**AL LT LV MK RO SI**

(30) Priorität: **19.10.1999 DE 19950362**

(71) Anmelder:
**Infineon Technologies AG
81669 München (DE)**

(72) Erfinder:
• **Rösner, Wolfgang, Dr.
81739 München (DE)**

• **Schulz, Thomas
81737 München (DE)**
• **Risch, Lothar, Dr.
85579 Neubiberg (DE)**
• **Hofmann, Franz, Dr.
80995 München (DE)**

(74) Vertreter:
**Fischer, Volker, Dipl.-Ing. et al
Epping Hermann & Fischer
Ridlerstrasse 55
80339 München (DE)**

(54) **DRAM-Zellenanordnung und Verfahren zu deren Herstellung**

(57) Eine Speicherzelle umfaßt einen Speichertransistor (S) und einen Transfertransistor (T). Eine Gateelektrode des Transfertransistors (T) und eine Kontroll-Gateelektrode des Speichertransistors (S) sind mit einer Wortleitung (W) verbunden. Der Speichertransistor (S) weist eine Floating-Gateelektrode auf, die durch ein erstes Dielektrikum von einem Kanalgebiet des Speichertransistors (S) getrennt ist und mit einem ersten Source-/Drain-Gebiet des Transfertransistors (T) verbunden ist. Die Kontroll-Gateelektrode ist durch ein zweites Dielektrikum von der Floating-Gateelektrode getrennt. Ein erstes Source-/Drain-Gebiet des Speichertransistors (S) ist mit einer Bitleitung (B) verbunden, die quer zur Wortleitung (W) verläuft. Vorzugsweise sind der Speichertransistor (S) und der Transfertra nsistor (T) von unterschiedlichen Leitfähigkeitstypen. Beim Schreiben von Information leitet der Transfertransistor (T) und sperrt der Speichertransistor (S). Beim Auslesen von Information sperrt der Transfertransistor (T) und leitet der Speichertransistor (S).

FIG 1

EP 1 098 370 A2

## Beschreibung

Die Erfindung betrifft eine DRAM-Zellenanordnung, das heißt eine Speicherzellenanordnung mit dynamischem wahlfreiem Zugriff.

Als eine Speicherzelle einer DRAM-Zellenanordnung wird derzeit meist eine sogenannte Ein-Transistor-Speicherzelle eingesetzt. Eine solche Speicherzelle umfaßt einen Transistor und einen Kondensator, auf dem die Information in Form einer Ladung gespeichert ist. Durch Ansteuerung des Transistors über eine Wortleitung kann die Ladung auf dem Kondensator über eine Bitleitung ausgelesen werden. Da die Ladung des Kondensators die Bitleitung treibt und ein durch die Ladung erzeugtes Signal trotz Hintergrundrauschen erkennbar bleiben soll, muß der Kondensator eine Mindestkapazität aufweisen. Um eine möglichst hohe Packungsdichte der DRAM-Zellenanordnung zu erzielen, werden Kondensatoren mit kompliziert gestalteten Oberflächen oder mit Kondensatordielektrika aus speziellen Materialien mit hohen Dielektrizitätskonstanten vorgeschlagen.

Bei einer alternativen DRAM-Zellenanordnung wird der hohe Prozeßaufwand zur Erzeugung von Kondensatoren mit kleinem Platzbedarf und großer Kapazität umgangen. In M. Heshami et al "250-MHz Skewed-Clock Pipelined Date Buffer", IEEE Journal of Solid-State Circuits, Vol. 31, No. 3, März 1996, 376, wird eine DRAM-Zellenanordnung beschrieben, bei der eine Speicherzelle eine selbstverstärkende dynamische Speicherzelle ist, die einen ersten Auswahltransistor, einen Speichertransistor und einen zweiten Auswahltransistor umfaßt. Der erste Auswahltransistor ist zwischen einer ersten Bitleitung und einer Gateelektrode des Speichertransistors geschaltet. Eine Gateelektrode des ersten Auswahltransistors ist mit einer ersten Wortleitung verbunden. Der zweite Auswahltransistor ist zwischen einem Source-/Drain-Gebiet des Speichertransistors und einer zweiten Bitleitung geschaltet. Eine Gateelektrode des zweiten Auswahltransistors ist mit einer zweiten Wortleitung verbunden. Ein weiteres Source-/Drain-Gebiet des Speichertransistors ist mit einem Spannungsanschluß verbunden. Wie bei der Ein-Transistor-Speicherzelle wird die Information in Form einer elektrischen Ladung gespeichert. Die elektrische Ladung muß jedoch nicht direkt die Bitleitung treiben, sondern wird auf der Gateelektrode des Speichertransistors gespeichert und dient nur zu dessen Steuerung, wozu schon eine sehr geringe Menge an elektrischer Ladung ausreicht. Zum Schreiben einer Information auf die Gateelektrode des Speichertransistors wird der erste Auswahltransistor über die erste Wortleitung angesteuert, so daß sich an der Gateelektrode des Speichertransistors eine Spannung einstellt, die abhängig von einer Spannung an der ersten Bitleitung ist, dessen Größe wiederum von der zu schreibenden Information abhängt. Zum Auslesen der Information wird der zweite Auswahltransistor über die zweite Wortleitung angesteuert. Je nach Information, das heißt je nach Spannung auf der Gateelektrode des Speichertransistors, ist der Speichertransistor leitend oder gesperrt, und es fließt ein Strom zwischen dem Spannungsanschluß und der zweiten Bitleitung oder nicht.

Ein EPROM ist eine nichtflüchtige Speicherzellenanordnung, bei der die Information im Gegensatz zur DRAM-Zellenanordnung nicht ständig wieder aufgefrischt werden muß. Die Information wird in Form von mindestens zwei unterschiedlichen Einsatzspannungen von Transistoren gespeichert. Zum Auslesen einer Information eines der Transistoren wird an eine Kontroll-Gateelektrode des Transistors eine Spannung angelegt, die zwischen den zwei Einsatzspannungen liegt. Je nachdem ob ein Strom durch den Transistor fließt oder nicht, wird der logische Wert Null oder Eins ausgelesen. Durch eine Floating Gateelektrode, die elektrisch isoliert und zwischen der Kontroll-Gateelektrode und einem Kanalgebiet des Transistors angeordnet ist, kann die Einsatzspannung des Transistors eingestellt werden. Dazu wird ein Spannungsabfall zwischen der Kontroll-Gateelektrode und dem Kanalgebiet oder einem Source-/Drain-Gebiet des Transistors erzeugt, der ein Tunneln von Elektronen in die oder aus der Floating-Gateelektrode bewirkt. Unterschiedliche Ladungen der Floating-Gateelektorde führen zu unterschiedlichen Einsatzspannungen des Transistors. Da die Floating-Gateelektrode vollständig isoliert ist, gibt es keine Leckströme und die Information muß nicht wieder aufgefrischt werden.

In der Literaturstelle IEEE Transactions on Electron Devices, Band 41, Nr. 6, Juni 1994, Seiten 926 bis 930 ist eine DRAM-Zellenanordnung mit einem p-Kanal-Schreibtransistor und einem n-Kanal-Lesetransistor beschrieben, welcher ein floatendes Gate aufweist. Die Steuer-Gateelektroden beider Transistoren sind an eine Wortleitung angeschlossen. Einer der Source-/Drain-Anschlüsse des Lesetransistors liegt auf einem Versorgungspotential, der andere seiner Source-/Drain-Anschlüsse ist an eine Bitleitung angeschlossen. Die Source-/Drain-Anschlüsse des Schreibtransistors sind einerseits an das floatende Gate des Lesetransistors, andererseits an die Bitleitung angeschlossen.

In der US 5 220 530 ist eine Speicherzelle mit einem Zugriffstransistor, dessen Gateelektrode an eine Wortleitung angeschlossen ist, und einem weiteren Transistor mit floatendem Gate gezeigt. Die Source-/Drain-Anschlüsse des Zugriffstransistors sind einerseits an eine Bitleitung, andererseits an die Steuer-Gateelektrode des weiteren Transistors angeschlossen. Die Source-/Drain-Anschlüsse des weiteren Transistors sind einerseits an die Bitleitung und andererseits an ein Versorgungspotential angeschlossen.

Der Erfindung liegt das Problem zugrunde, eine DRAM-Zellenanordnung anzugeben, die bei zugleich hoher Packungsdichte mit niedrigem Prozeßaufwand herstellbar ist. Ferner soll ein Verfahren zum Betrieb einer solchen DRAM-Zellenanordnung und ein Verfahren zur Erzeugung einer solchen DRAM-Zellenanordnung angegeben werden.

Das Problem wird gelöst durch eine DRAM-Zellenanordnung mit mehreren Speicherzellen, bei der die Speicherzellen jeweils einen Speichertransistor und einen Transfertransistor aufweisen. Eine Gateelektrode des Transfertransistors ist mit einer Wortleitung verbunden. Der Speichertransistor weist eine Floating-Gateelektrode auf, die durch ein erstes Dielektrikum von einem Kanalgebiet des Speichertransistors getrennt ist und mit einem ersten Source-/Drain-Gebiet des Transfertransistors verbunden ist. Der Speichertransistor weist eine Kontroll-Gateelektrode auf, die durch ein zweites Dielektrikum von der Floating-Gateelektrode getrennt ist und mit der Wortleitung verbunden ist. Ein erstes Source-/Drain-Gebiet des Speichertransistors ist mit einer Bitleitung verbunden, die quer zur Wortleitung verläuft. Ein zweites Source-/Drain-Gebiet des Speichertransistors und ein zweites Source-/Drain-Gebiet des Transferstransistors sind mit einem Spannungsanschluß verbunden.

Im folgenden wird ein Verfahren zum Betrieb einer solchen DRAM-Zellenanordnung angegeben, das ebenfalls das Problem löst:

Zum Schreiben von Information auf die Speicherzelle wird die Wortleitung mit einer solchen Schreibspannung beaufschlagt, daß der Transfertransistor leitet. Ferner wird beim Schreiben der Information die Bitleitung mit einer Bitleitungsspannung beaufschlagt, die abhängig von der zu speichernden Information ist, so daß die Floating-Gateelektrode mit einer von der Bitleitungsspannung abhängigen Ladung geladen wird. Die Information ist also in Form einer Ladung auf der Floating-Gateelektrode gespeichert.

Zum Auslesen der Information der Speicherzelle wird die Wortleitung mit einer solchen Lesespannung beaufschlagt, daß ab hängig von der Ladung auf der Floating-Gateelektrode ein Signal an der Bitleitung erzeugt wird.

Soll auf der Speicherzelle entweder die logische Eins oder die logische Null gespeichert werden, so kann die Bitleitungsspannung abhängig von der zu speichernden Information derart sein, daß der Speichertransistor beim Auslesen der logischen Eins leitet und beim Auslesen einer logischen Null sperrt oder umgekehrt. Leitet der Speichertransistor, so kann an der Bitleitung eine Spannungsänderung und/oder eine Stromänderung gemessen werden. Sperrt der Speichertransistor ändern sich Spannung und Strom der Bitleitung nicht. In diesem Fall besteht das Signal an der Bitleitung darin, daß nichts passiert.

Alternativ kann der Speichertransistor abhängig von der Ladung auf der Floating-Gateelektrode, das heißt abhängig von der gespeicherten Information, unterschiedlich gut leiten.

Die Bitleitungsspannung bestimmt die Ladung auf der Floating-Gateelektrode und diese wiederum bestimmt die Einsatzspannung des Speichertransistors. Verschiedene Einsatzspannungen führen beim Auslesen zu verschiedenen Signalen an der Bitleitung. Wird die Einsatzspannung durch die Lesespannung nicht überschritten, so sperrt der Speichertransistor.

Zwischen dem Schreiben und dem Auslesen der Information wird die Wortleitung mit einer solchen Ruhespannung beaufschlagt, daß der Speichertransistor und der Transfertransistor sperren.

Da die Speicherzelle keinen Kondensator aufweist, ist es besonders einfach, die Speicherzelle mit einem kleinen Platzbedarf zu erzeugen, so daß die DRAM-Zellenanordnung eine besonders hohe Pakkungsdichte aufweist. Es ist kein erhöhter Prozeßaufwand erforderlich, da auf komplizierte Oberflächen und besondere Materialien mit hohen Dielektrizitätskonstanten verzichtet werden können.

Die Speicherzelle kann beispielsweise nur zwei Transistoren aufweisen, so daß die Packungsdichte der erfindungsgemäßen DRAN-Zellenanordnung einfacher erhöht werden kann als bei einer DRAM-Zellenanordnung, bei der eine Speicherzelle drei Transistoren umfaßt.

Die Floating-Gateelektrode floatet nicht wirklich, da der Transfertransistor Leckströme aufweisen kann, so daß die Ladung auf Floating-Gateelektrode sich im Laufe der Zeit verändern kann. Es ist in der Regel ein Auffrischen der gespeicherten Information erforderlich.

Da beim Schreiben alle Transfertransistoren, die mit der Wortleitung, die mit der Schreibspannung beaufschlagt wird, verbunden sind, leiten, ist es vorteilhaft, wenn die zugehörigen Speicherzellen zugleich programmiert werden.

Vorzugsweise ist die Schreibspannung derart, daß der Speichertransistor beim Schreiben sperrt. In diesem Fall fließt beim Schreiben kein Strom durch den Speichertransistor und der Leistungsverbrauch ist folglich geringer. Sind der Speichertransistors und der Transfertransistor vom selben Leitfähigkeitstyp, so ist in diesem Fall die Einsatzspannung des Speichertransistors höher als die des Transfertransistors. Die Schreibspannung liegt zwischen der Einsatzspannung des Speichertransistors und der Einsatzspannung des Transfertransistors.

Die Lesespannung ist vorzugsweise derart, daß der Transfertransistor beim Auslesen sperrt. Die Ladung auf der Floating-Gateelektrode bleibt also beim Auslesen im wesentlichen konstant. Dies bedeutet zum einen, daß die Signale an der Bitleitung ausgeprägter sind und z.B. das Signal der logischen Eins sich von dem Signal der logischen Null stärker unterscheidet. Da die Information weniger schnell verlorengeht, muß die Information weniger oft aufgefrischt werden. Sind der Speichertransistor und der Transfertransistor vom selben Leitfähigkeitstyp, so ist in diesem Fall die Einsatzspannung des Transfertransistors höher als die Einsatzspannung des Speichertransistors. Die Lesespannung liegt in diesem Fall zwischen der Einsatzspannung des Transfertransistors und der Einsatzspannung des Speichertransistors.

Um sowohl einen kleineren Leistungsverbrauch als auch ausgeprägtere Signale an der Bitleitung und größere Auffrischzeiten zu erhalten, ist es vorteilhaft, wenn der Speichertransistor von einem Leitfähigkeitstyp ist, der entgegengesetzt zu einem Leitfähigkeitstyp des Transfertransistors ist. In diesem Fall kann die Schreibspannung so gewählt werden, daß der Speichertransistor sperrt und der Transfertransistor leitet. Die Lesespannung kann so gewählt werden, daß der Transfertransistor sperrt und der Speichertransistor leitet.

Beispielsweise ist der Transfertransistor ein n-Kanal-Transistor, während der Speichertransistor ein p-Kanal-Transistor ist. Alternativ ist der Transfertransistor ein p-Kanal-Transistor und der Speichertransistor ein n-Kanal-Transistor.

Ist der Transfertransistor ein n-Kanal-Transistor und der Speichertransistor ein p-Kanal-Transistor, so ist die Schreibspannung beispielsweise gleich einer positiven Betriebsspannung und die Lesespannung beispielsweise gleich Null Volt. Die Ruhespannung ist größer als Null Volt und kleiner als die Betriebsspannung.

Ist der Transfertransistor ein p-Kanal-Transistor und der Speichertransistor ein n-Kanal-Transistor, so ist die Schreibspannung beispielsweise gleich Null Volt und die Lesespannung beispielsweise gleich einer positiven Betriebsspannung. Die Ruhespannung ist größer als Null Volt und kleiner als die Betriebsspannung.

Die Bitleitungsspannung ist abhängig von der zu speichernden Information und ist gleich der Betriebsspannung oder gleich Null Volt. Beispielsweise ist die Bitleitungsspannung gleich der Betriebsspannung, wenn die logische Eins gespeichert werden soll, und gleich Null Volt, wenn die logische Null gespeichert werden soll.

Zur Erhöhung der Packungsdichte ist es vorteilhaft, wenn ein zweites Source-/Drain-Gebiet des Speichertransistors und ein zweites Source-/Drain-Gebiet des Transfertransistors mit demselben Spannungsanschluß verbunden sind. Alternativ ist das zweite Source-/Drain-Gebiet des Speichertransistors an einen anderen Spannungsanschluß angeschlossen als das zweite Source-/Drain-Gebiet des Transfertransistors.

Der Spannungsanschluß wird auf ein konstantes Potential gehalten.

Ist der Transfertransistor ein p-Kanal-Transistor und der Speichertransistor ein n-Kanal-Transistor, so wird der Spannungsanschluß beispielsweise auf einer Spannung gehalten, die zwischen Null Volt und der Betriebsspannung liegt.

Eine besonders hohe Packungsdichte wird erzielt, wenn der Transfertransistor als Dünnfilmtransistor ausgestaltet ist. Die Source-/Drain-Gebiete und das Kanalgebiet des Transfertransistors bestehen in diesem Fall aus Polysilizium und können innerhalb einer dünnen Schicht erzeugt werden. Der Transfertransistor kann als Dünnfilmtransistor auf Teilen des Speichertransistors, der in einem Substrat angeordnet ist, angeordnet sein, so daß sich eine besonders hohe Packungsdichte ergibt.

Zur Erhöhung der Packungsdichte ist es vorteilhaft, wenn die Kontroll-Gateelektrode mit der Gateelektrode des Transfertransistors übereinstimmt.

Zur Erhöhung der Packungsdichte ist es vorteilhaft, wenn die Floating-Gateelektrode mit dem ersten Source-/Drain-Gebiet des Transfertransistors übereinstimmt.

Beispielsweise sind das erste Source-/Drain-Gebiet, das Kanalgebiet und das zweite Source-/Drain-Gebiet des Speichertransistors angrenzend an eine Oberfläche eines Substrats im Substrat nebeneinander angeordnet. Auf dem Substrat ist eine isolierende Schicht angeordnet. Die isolierende Schicht weist eine Vertiefung auf, die bis zum Kanalgebiet des Speichertransistors reicht. Das erste Dielektrikum bedeckt mindestens den Boden der Vertiefung. Eine Schicht aus Polysilizium ist auf der isolierenden Schicht angeordnet und bedeckt Flanken der Vertiefung und das erste Dielektrikum am Boden der Vertiefung, ohne die Vertiefung aufzufüllen. Das erste Source/Drain-Gebiet des Transfertransistors ist ein Teil der Schicht aus Polysilizium, der auf dem ersten Dielektrikum am Boden der Vertiefung angeordnet ist. Das zweite Source-/Drain-Gebiet des Transfertransistors ist ein Teil der Schicht aus Polysilizium, der auf der isolierenden Schicht angeordnet ist. Das Kanalgebiet des Transfertransistors ist ein Teil der Schicht aus Polysilizium, der an den Flanken der Vertiefung angeordnet ist. Das zweite Dielektrikum ist auf der Schicht aus Polysilizium angeordnet. Die Kontroll-Gateelektrode ist auf dem zweiten Dielektrikum angeordnet. Der Transfertransistor ist als vertikaler Dünnfilmtransistor ausgestaltet.

Eine solche DRAM-Zellenanordnung kann beispielsweise wie folgt erzeugt werden:

Im Substrat wird das erste Source-/Drain-Gebiet, das Kanalgebiet und das zweite Source-/Drain-Gebiet des Speichertransistors nebeneinander angrenzend an die Oberfläche des Substrats erzeugt. Auf dem Substrat wird die isolierende Schicht erzeugt, in der die Vertiefung erzeugt wird, die bis zum Kanalgebiet des Speichertransistors reicht. Mindestens auf dem Boden der Vertiefung wird das erste Dielektrikum erzeugt. Die Schicht aus Polysilizium wird insitu von einem ersten Leitfähigkeitstyp dotiert abgeschieden, so daß sie auf der isolierenden Schicht, den Flanken der Vertiefung und dem ersten Dielektrikum am Boden der Vertiefung angeordnet ist. Die Dicke der Schicht aus Polysilizium ist derart, daß die Vertiefung durch sie nicht aufgefüllt wird. Anschließend wird eine Implantation im wesentlichen senkrecht zur Oberfläche des Substrats mit Ionen von einem zweiten, zum ersten Leitfähigkeitstyp entgegengesetzten Leitfähigkeitstyp dotiert, so daß aus der Schicht aus Polysilizium das vom zweiten Leitfähigkeitstyp dotierte erste Source/Drain-Gebiet des Transfertransistors erzeugt wird, das auf dem ersten Dielektrikum am Boden der Vertiefung angeordnet ist, und daß aus der Schicht aus Polysilizium das vom zweiten Leitfähigkeitstyp dotierte zweite Source-/Drain-Gebiet des Transfertransistors erzeugt wird, das auf der isolierenden Schicht angeordnet ist und daß aus der Schicht aus Polysilizium das vom ersten Leitfähigkeitstyp dotierte Kanalgebiet des Transfertransistors erzeugt wird, das an den Flanken der Vertiefung angeordnet ist. Anschließend werden das zweite Dielektrikum auf der Schicht aus Polysilizium und darüber die Kontroll-Gateelektrode des Speichertransistors erzeugt.

Das erste Dielektrikum kann vor Erzeugung der isolierenden Schicht auf dem Substrat erzeugt werden. Alternativ kann das erste Dielektrikum nach Erzeugung der Vertiefung erzeugt werden. Wird in diesem Fall das erste Dielektrikum durch Abscheiden von isolierendem Material erzeugt, bedeckt das erste Dielektrikum neben dem Boden der Vertiefung auch die Flanken der Vertiefung.

Der Speichertransistor wird besonders gut angesteuert, wenn eine Länge seines Kanalgebiets etwa gleich einer Länge der Floating-Gateelektrode am Boden der Vertiefung bzw. einer Länge der Kontroll-Gateelektrode am Boden der Vertiefung ist. Da die Floating-Gateelektrode ein Teil der Schicht aus Poly-Silizium ist, der nicht an die Flanken der Vertiefung angrenzt, ist es folglich vorteilhaft, wenn die Vertiefung um etwa die doppelte Dicke der Schicht aus Polysilizium länger ist als das Kanalgebiet des Speichertransistors.

Um die Vertiefung selbstjustiert bezüglich dem Kanalgebiet des Speichertransistors zu erzeugen, ist es vorteilhaft, auf der Oberfläche des Substrats eine Maske zu erzeugen, die mindestens das Kanalgebiet des Speichertransistors bedeckt. Mit Hilfe der Maske wird eine Implantation durchgeführt, so daß das erste Source-/Drain-Gebiet und das zweite Source-/Drain-Gebiet des Speichertransistors erzeugt werden. Die Maske verhindert dabei, daß das Kanalgebiet des Speichertransistors implantiert wird. Anschließend werden angrenzend an die Maske Spacer gebildet. Zur Erzeugung der isolierenden Schicht wird isolierendes Material abgeschieden und abgetragen, bis die Maske und die Spacer freigelegt werden. Die Vertiefung wird durch Entfernung der Maske und der Spacer erzeugt. Die Länge der Vertiefung ist folglich gleich der Summe aus der Länge der Maske und der doppelten Dicke der Spacer. Die Dicke der Schicht aus Polysilizium ist vorzugsweise etwa gleich der Dicke der Spacer.

Eine besonders hohe Packungsdichte läßt sich erzielen, wenn ein Kontakt zum Spannungsanschluß zugleich das zweite Source/Drain-Gebiet des Speichertransistors und das zweite Source/Drain-Gebiet des Transfertransistors kontaktiert. Dazu ist in der isolierenden Schicht mindestens ein Teil eines Kontaktlochs angeordnet, das bis zum zweiten Source-/Drain-Gebiet des Speichertransistors reicht. Ein Kontakt füllt das Kontaktloch derart, daß er das zweite Source-/Drain-Gebiet des Transfertransistors überlappt.

Über der Kontroll-Gateelektrode kann ein Zwischenoxid angeordnet sein. Das Kontaktloch kann das Zwischenoxid durchtrennen und teilweise bis zum zweiten Source-/Drain-Gebiet des Transfertransistors und teilweise bis zum zweiten Source-/Drain-Gebiet des Speichertransistors reichen. Zur Erzeugung eines solchen Kontakts wird zunächst die Schicht aus Polysilizium so strukturiert, daß sie auf der isolierenden Schicht eine für die Kontaktierung des zweiten Source-/Drain-Gebiets des Transfertransistors geeignete Ausdehnung aufweist. Nach der Erzeugung der Kontroll-Gateelektrode wird das Zwischenoxid aufgebracht. Durch maskiertes Ätzen des Zwischenoxids und der isolierenden Schicht selektiv zur Schicht aus Polysilizium wird das Kontaktloch derart erzeugt, daß ein Teil des Kontaktlochs bis zum zweiten Source-/Drain-Gebiet des Speichertransistors reicht und ein weiterer Teil des Kontaktlochs bis zur Schicht aus Polysilizium reicht. Anschließend wird das Kontaktloch mit einem Kontakt gefüllt.

Bei einem n-Kanal-Transistor sind dessen Source/Drain-Gebiete n-dotiert. Das Kanalgebiet des n-Kanal-Transistors kann p-dotiert, undotiert oder schwach n-dotiert sein. Bei einem p-Kanal-Transistor sind dessen Source/Drain-Gebiete p-dotiert. Das Kanalgebiet des p-Kanal-Transistors kann n-dotiert, undotiert oder schwach p-dotiert sein.

Im folgenden wird ein Ausführungsbeispiel der Erfindung anhand der Figuren näher erläutert.

Figur 1 zeigt einen Querschnitt durch ein Substrat, nachdem ein erstes Source-/Drain-Gebiet, ein Kanalgebiet und ein zweites Source-/Drain-Gebiet eines Speichertranesistors, ein erstes Dielektrikum, eine Maske, Spacer und eine isolierende Schicht erzeugt wurden.

Figur 2 zeigt den Querschnitt aus Figur 1, nachdem eine Vertiefung, eine Schicht aus Polysilizium und ein zweites Dielektrikum erzeugt wurden.

Figur 3 zeigt den Querschnitt aus Figur 2, nachdem ein erstes Source-/Drain-Gebiet, ein Kanalgebiet und ein zweites Source-/Drain-Gebiet eines Transfertransistors, eine Kontroll-Gateelektrode des Speichertransistors, ein Zwischenoxid und ein Kontakt erzeugt wurden.

Figur 4 zeigt ein Schaltbild einer Speicherzelle.

Figur 5 zeigt ein Ersatzschaltbild des Speichertransistors.

Die Figuren sind nicht maßstabsgerecht.

Im Ausführungsbeispiel ist als Ausgangsmaterial ein Substrat 1 aus p-dotiertem Silizium vorgesehen. Durch Erzeugung von Gräben und Füllen mit isolierendem Material werden isolierende Strukturen (nicht dargestellt) erzeugt, die zueinander benachbarte zu erzeugende Speicherzellen voneinander trennen.

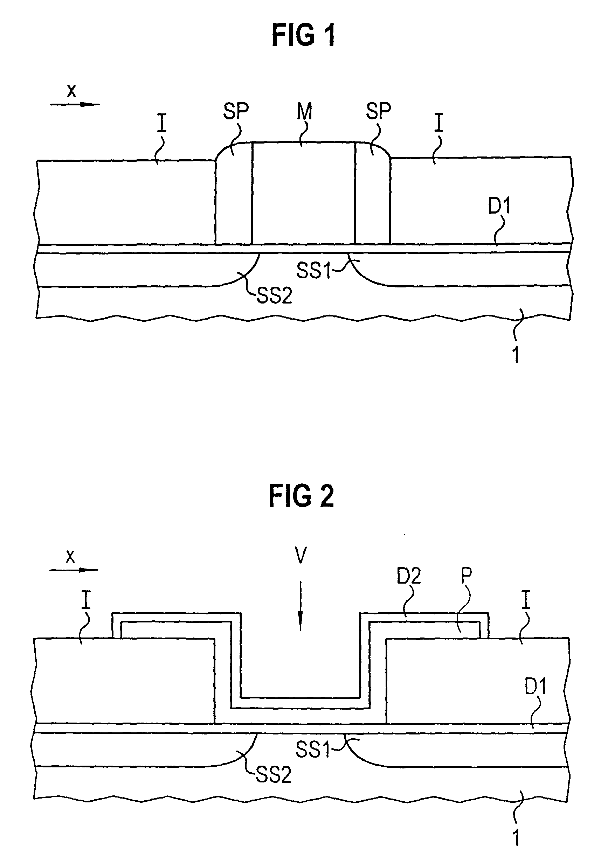

Durch thermische Oxidation wird ein ca. 5 nm dickes erstes Dielektrikum D1 erzeugt (siehe Figur 1).

Zur Erzeugung einer Maske M wird Siliziumnitrid in einer Dicke von ca. 300 nm abgeschieden und durch maskiertes Ätzen strukturiert. Die Maske M bedeckt für jede Speicherzelle ein streifenförmiges Gebiet, dessen Abmessungen 300 nm und 500 nm betragen und das senkrecht zu einer x-Achse x verläuft.

Die Maske M überlappt die isolierenden Strukturen und teilt von den isolierenden Strukturen umgebene Bereiche von den zu erzeugenden Speicherzellen jeweils in zwei Hälften.

Zur Erzeugung von ersten Source-/Drain-Gebieten SS1 und zweiten Source-/Drain-Gebieten SS2 von Speichertransistoren S wird eine Implantation mit Arsen durchgeführt. Unter der Maske M angeordnete Teile des Substrats 1 sind als Kanalgebiete der Speichertransistoren S geeignet und sind zwischen den ersten Source-/Drain-Gebieten SS1 und den zweiten Source/Drain-Gebieten SS2 der Speichertransistoren S angeordnet (siehe Figur 1).

Zur Erzeugung von Spacern SP wird Siliziumnitrid in einer Dicke von ca. 100 nm abgeschieden und rückgeätzt bis das erste Dielektrikum D1 freigelegt wird (siehe Figur 1).

Zur Erzeugung einer isolierenden Schicht I wird $SiO_2$ in einer Dicke von ca. 300 nm abgeschieden und durch chemisch-mechanisches Polieren planarisiert bis die Maske M freigelegt wird (siehe Figur 1). Anschließend wird die isolierende Schicht I ca. 100 nm weit selektiv zu Siliziumnitrid rückgeätzt, so daß die Spacer SP teilweise freigelegt werden.

Zur Erzeugung einer Vertiefung V pro Speicherzelle wird Siliziumnitrid selektiv zu $SiO_2$ naß mit zum Beispiel heißer Phosphorsäure geätzt, so daß Teile des ersten Dielektrikums D1 freigelegt werden. Die Vertiefungen V reichen bis zu den Kanalgebieten der Speichertransistoren S. An den Böden der Vertiefungen V sind die Teile des ersten Dielektrikums D1 angeordnet.

Anschließend wird eine ca. 50 nm, dicke Schicht aus insitu n-dotiertem Polysilizium P abgeschieden. Mit Hilfe einer Maske aus Photolack (nicht dargestellt), die rechteckige Bereiche, in denen jeweils eine der Vertiefungen V angeordnet sind, bedeckt, wird die Schicht aus Polysilizium P strukturiert. Die rechteckigen Bereiche weisen jeweils eine zur x-Achse x parallele Seitenlänge auf, die ca. 800 nm beträgt, und eine zur x-Achse x senkrechte Abmessung, die ca. 900 nm beträgt. Es entstehen voneinander getrennte Teile der Schicht aus Polysilizium P (siehe Figur 2).

Durch eine thermische Oxidation wird auf der Schicht aus Polysilizium P ein ca. 8 nm dickes zweites Dielektrikum D2 erzeugt.

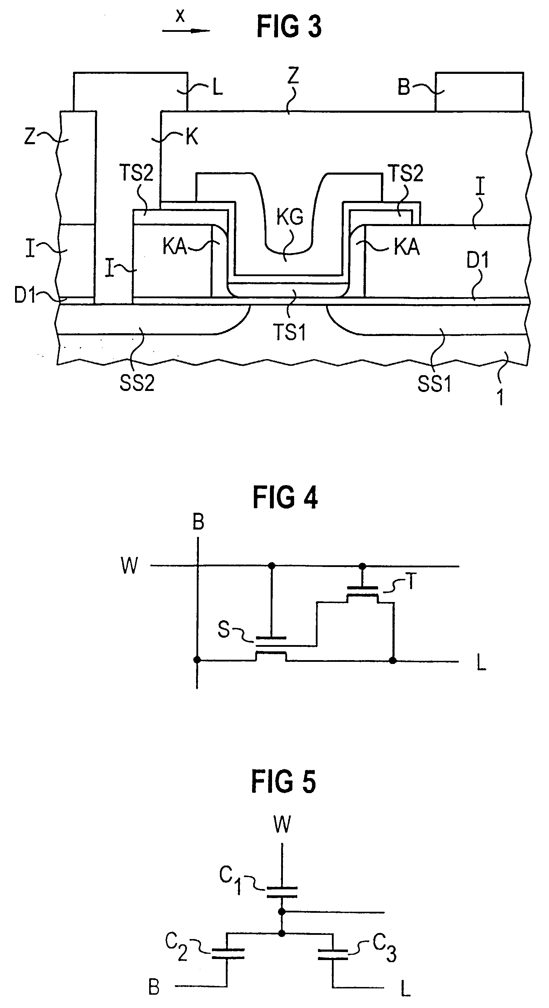

Durch eine senkrechte Implantation mit Bor-Ionen wird die Schicht aus Polysilizium P so dotiert, daß aus Teilen der Schicht aus Polysilizium P, die an Böden der Vertiefungen V angeordnet sind, erste Source-/Drain-Gebiete TS1 von Transfertransistoren T erzeugt werden, aus Teilen der Schicht aus Polysilizium P, die auf der isolierenden Schicht I angeordnet sind, zweite Source-/Drain-Gebiete TS2 der Transfertransistoren T und aus Teilen der Schicht aus Polysilizium P, die an Flanken der Vertiefungen V angeordnet sind, Kanalgebiete KA der Transfertransistoren T erzeugt werden (siehe Figur 3). Eine zur x-Achse parallele Ausdehnung des zweiten Source/Drain-Gebiets TS2 des Transfertransistors T einer Speicherzelle, die oberhalb des zweiten Source/Drain-Gebiets SS2 des Speichertransistors S der Speicherzelle verläuft, beträgt ca. 250 nm. Eine zur x-Achse parallele weitere Ausdehnung des zweiten Source/Drain-Gebiets TS2 des Transfertransistors T, die oberhalb des ersten Source/Drain-Gebiets SS1 des Speichertransistors S verläuft, beträgt ca. 150 nm. Zur x-Achse senkrechte Ausdehnungen des zweiten Source/Drain-Gebiets TS2 des Transfertransistors T betragen ca. 900 nm. Das zweite Source/Drain-Gebiet TS2 des Transfertransistors T umgibt die Vertiefung V der Speicherzelle.

Die ersten Source/Drain-Gebiete TS1 der Transfertransistoren wirken gleichzeitig als Floating-Gateelektroden der Speichertransistoren.

Anschließend wird insitu n-dotiertes Polysilizium in einer Dicke von ca. 150 nm abgeschieden und durch ein photolithographisches Verfahren streifenförmig strukturiert. Dadurch werden Wortleitungen W erzeugt, die senkrecht zur x-Achse verlaufen, ca. 600 nm breit sind und die Vertiefungen V bedecken. Die Wortleitungen W sind auf dem zweiten Dielektrikum D2 und auf der isolierenden Schicht I angeordnet. Teile der Wortleitungen W, die auf dem zweiten Dielektrikum D2 angeordnet sind, wirken als Kontroll-Gateelektroden KG der Speichertransistoren S (siehe Figur 3).

Anschließend wird $SiO_2$ in einer Dicke von ca. 600 nm abgeschieden und planarisiert, so daß ein ca. 400 nm dickes Zwischenoxid Z erzeugt wird (siehe Figur 3).

Durch maskiertes Ätzen von $SiO_2$ selektiv zu Silizium werden Kontaktlöcher geöffnet. Pro Speicherzelle werden zwei Kontaktlöcher erzeugt. Das erste Kontaktloch (nicht dargestellt) reicht bis zum ersten Source-/Drain-Gebiet SS1 des Speichertransistors S. Das zweite Kontaktloch wird so erzeugt, daß ein erster Teil bis zum zweiten Source-/Drain-Gebiet SS2 des Speichertransistors S und ein zweiter Teil bis zum zweiten Source-/Drain-Gebiet TS2 des Transfertransistors T reicht (siehe Figur 3).

Zur Erzeugung von ersten Kontakten in den ersten Kontaktlöchern (nicht dargestellt) und von zweiten Kontakten K in den zweiten Kontaktlöchern wird Wolfram in einer Dicke von ca. 400 nm abgeschieden und durch chemisch-mechanisches Polieren planarisiert, bis das Zwischenoxid Z freigelegt wird. Zur Erzeugung von Bitleitungen B und von Leitungen L wird anschließend Aluminium in einer Dicke von ca. 400 nm abgeschieden und durch Ätzen streifenförmig strukturiert. Die Bitleitungen B und die Leitungen L sind ca. 400 nm breit. Die Bitleitungen B sind mit den ersten Kontakten verbunden. Die Leitungen L sind mit den zweiten Kontakten K und mit einem Spannungsanschluß verbunden.

In Figur 4 ist das Schaltbild einer Speicherzelle der erzeugten DRAM-Zellenanordnung dargestellt. Die Speicherzelle weist einen Speichertransistor S und einen Transfertransistor T auf. Ferner sind eine Wortleitung W, eine Leitung L und eine Bitleitung B dargestellt.

Im folgenden wird ein Verfahren beschrieben, wie die erzeugte DRAM-Zellenanordnung betrieben werden kann:

Figur 5 zeigt ein Ersatzschaltbild des Speichertransistors S.

Die Kapazität $C_1$ wird gebildet durch die Kontroll Gateelektrode KG und durch die Floating-Gateelektrode. Die Kapazität $C_2$ wird gebildet durch die Floating-Gateelektrode und das erste Source-/Drain-Gebiet SSl des Speichertransistors S. Die dritte Kapazität $C_3$ wird gebildet durch die Floating-Gateelektrode und das zweite Source-/Drain-Gebiet SS2 des Speichertransistors S.

Der Speichertransistor S wird so erzeugt, daß seine Einsatzspannung $\frac{11}{16} \times V_{DD}$ beträgt. $V_{DD}$ ist dabei die Betriebsspannung und ist in diesem Ausführungsbeispiel gleich 2 Volt.

Der Transfertransistor T wird so erzeugt, daß seine Einsatzspannung $-\frac{3}{16} \times V_{DD}$ beträgt.

Der Speichertransistor S wird so erzeugt, daß $C_2 = C_3$ ist und $C_1 = 2 \times C_2$ ist.

Der Spannungsanschluß wird konstant auf $1/4\ V_{DD}$ gehalten.

**Schreiben:**

Zum Schreiben einer Information auf die Speicherzelle wird die Wortleitung W mit einer Schreibspannung beaufschlagt, die Null Volt beträgt.

Zum Schreiben einer logischen Null wird die Bitleitung B mit einer Bitleitungsspannung beaufschlagt, die Null Volt beträgt. Es läßt sich berechnen, daß die Ladung, mit der die Floating-Gateelektrode dadurch geladen wird,

$$\frac{3}{16} \times 4 C_2 \times V_{DD}$$

beträgt.

Zum Schreiben einer logischen Eins wird die Bitleitung B mit einer Bitleitungsspannung beaufschlagt, die VDD beträgt. Es läßt sich berechnen, daß die Ladung, mit der die Floating Gateelektrode geladen wird,

$$-\frac{1}{16} \times 4 C_2 \times V_{DD}$$

beträgt.

Die Ladung auf der Floating-Gateelektrode und damit die Einsatzspannung des Speichertransistors S ist folglich abhängig von der gespeicherten Information.

Es läßt sich berechnen, daß der Transfertransistor T unabhängig von der Spannung an der Bitleitung B leitet.

Der Speichertransistor S ist unabhängig von der Spannung an der Bitleitung B gesperrt.

**Zwischen Schreiben und Lesen:**

Zwischen dem Schreiben und dem Lesen der Information wird die Wortleitung W mit einer Ruhespannung beaufschlagt, die $3/4\ V_{DD}$ beträgt. Es läßt sich berechnen, daß sowohl der Speichertransistor S als auch der Transfertransistor T gesperrt sind. Dabei kann die Spannung an der Bitleitung B beliebige Werte zwischen Null und $V_{DD}$ annehmen. Beim Auslesen bzw. Schreiben von Information auf Speicherzellen, die nicht mit dieser Wortleitung W verbunden sind, geht also bei der betrachteten Speicherzelle keine Ladung auf der Floating-Gateelektrode verloren und es fließt auch kein Strom, der zu einem unerwünschten Leistungsverbrauch führt.

**Auslesen:**

Zum Auslesen der Information der Speicherzelle wird die Bitleitung B mit einer Lesespannung beaufschlagt, die $V_{DD}$ beträgt. An die Bitleitung B wird Null Volt angelegt.

Es läßt sich berechnen, daß der Transfertransistor T unabhängig von der auf der Floating-Gateelektrode gespeicherten Ladung sperrt.

Wurde die logische Null auf der Speicherzelle gespeichert, so beträgt ein Spannungsunterschied zwischen der Floating Gateelektrode und dem ersten Source-/Drain-Gebiet des Spei chertransistors S $\frac{12}{16}\ V_{DD}$. Da die Einsatzspannung des Speichertransistors S kleiner ist, leitet der Speichertransistor S in diesem Fall.

Wurde die logische Eins auf der Speicherzelle gespeichert, so beträgt der Spannungsunterschied zwischen der Floating-Gateelektrode und dem ersten Source-/Drain-Gebiet des Speichertransistors S $\frac{1}{2}\ V_{DD}$. Weil dieser Spannungsabfall kleiner als die Einsatzspannung des Speichertransistors ist, sperrt der Speichertransistor S in diesem Fall.

Es sind viele Variationen des Ausführungsbeispiels denkbar, die ebenfalls im Rahmen der Erfindung liegen. So können Abmessungen der beschriebenen Schichten, Gebiete, Masken und Spacer an die jeweiligen Erfordernisse angepaßt werden. Dasselbe gilt für die Wahl der Materialien. Das Kanalgebiet des Speichertransistors, das erste Source-/Drain-Gebiet und das zweite Source-/Drain-Gebiet des Transfertransistors können statt p- auch n-dotiert sein. In diesem Fall sind das erste Source-/Drain-Gebiet und das zweite Source-/Drain-Gebiet des Speichertransistors und das Kanalgebiet des Transfertransistors p-dotiert.

**Patentansprüche**

1. DRAM-Zellenanordnung,

   - mit mehreren Speicherzellen,
   - bei der die Speicherzellen jeweils einen Speichertransistor (S) und einen Transfertransistor (T) aufweisen,
   - bei der eine Gateelektrode des Transfertransistors mit einer Wortleitung (W) verbunden ist,
   - bei der der Speichertransistor (S) eine Floating-Gateelektrode aufweist, die durch ein erstes Dielektrikum (D1) von einem Kanalgebiet des Speichertransistors (S) getrennt ist und mit einem ersten Source-/Drain-Gebiet (TS1) des Transfertransistors (T) verbunden ist,
   - bei der der Speichertransistor (S) eine Kontroll-Gateelektrode (KG) aufweist, die durch ein zweites Dielektrikum (D2) von der Floating-Gateelektrode getrennt ist und mit der Wortleitung (W) verbunden ist,
   - bei der ein erstes Source-/Drain-Gebiet (SS1) des Speichertransistors (S) mit einer Bitleitung (B) verbunden ist, die quer zur Wortleitung (W) verläuft, und
   - bei der ein zweites Source-/Drain-Gebiet (SS2) des Speichertransistors (S) und ein zweites Source-/Drain-Gebiet (TS2) des Transfertransistors (T) mit einem Spannungsanschluß verbunden sind.

2. DRAM-Zellenanordnung nach Anspruch 1,

   - bei der der Speichertransistor (S) von einem Leitfähigkeitstyp ist, der entgegengesetzt zu einem Leitfähigkeitstyp ist des Transfertransistors (T) ist.

3. DRAM-Zellenanordnung nach Anspruch 2,

   - bei der der Transfertransistors (T) ein p-Kanal-Transistor ist,
   - bei der der Speichertransistor (S) ein n-Kanal-Transistor ist.

4. DRAM-Zellenanordnung nach einem der Ansprüche 1 bis 3,

   - bei der der Transfertransistor (T) als Dünnfilmtransistor ausgestaltet ist.

5. DRAM-Zellenanordnung nach einem der Ansprüche 1 bis 4,

   - bei der die Kontroll-Gateelektrode (KG) mit der Gateelektrode des Transfertransistors (T) übereinstimmt,
   - bei der die Floating-Gateelektrode mit dem ersten Source-/Drain-Gebiet (TS1) des Transfertransistors (T) übereinstimmt.

6. DRAM-Zellenanordnung nach Anspruch 5,

   - bei der das erste Source-/Drain-Gebiet (SS1), das Kanalgebiet und das zweite Source-/Drain-Gebiet (SS2) des Speichertransistors (S) an eine Oberfläche eines Substrats (1) angrenzen und nebeneinander im Substrat (1) angeordnet sind,
   - bei der auf dem Substrat (1) eine isolierende Schicht (I) angeordnet ist,
   - bei der die isolierende Schicht (I) eine Vertiefung (V) aufweist, die bis zum Kanalgebiet des Speichertransistors (S) reicht,
   - bei der das erste Dielektrikum (D1) mindestens einen Boden der Vertiefung (V) bedeckt,
   - bei der eine Schicht aus Polysilizium (P) auf der isolierenden Schicht (I) angeordnet ist und Flanken der Vertiefung (V) und das erste Dielektrikum (D1) am Boden der Vertiefung (V) bedeckt, ohne die Vertiefung (V) aufzufüllen,
   - bei der das erste Source-/Drain-Gebiet (TS1) des Transfertransistors (T) ein Teil der Schicht aus Polysilizium (P) ist, der auf dem ersten Dielektrikum (D1) am Boden der Vertiefung (V) angeordnet ist,
   - bei der das zweite Source-/Drain-Gebiet (TS2) des Transfertransistors (T) ein Teil der Schicht aus Polysilizium (P) ist, der auf der isolierenden Schicht (I) angeordnet ist,
   - bei der das Kanalgebiet des Transfertransistors (T) ein Teil der Schicht aus Polysilizium (P) ist, der an den Flanken der Vertiefung (V) angeordnet ist
   - bei der das zweite Dielektrikum (D2) auf der Schicht aus Polysilizium (P) angeordnet ist,
   - bei der die Kontroll-Gateelektrode (KG) auf dem zweiten Dielektrikum (D2) angeordnet ist.

7. DRAM-Zellenanordnung nach Anspruch 6,

- bei der in der isolierenden Schicht (I) ein Kontaktloch angeordnet ist, das bis zum zweiten Source-/Drain-Gebiet (SS2) des Speichertransistors (S) reicht,
- bei dem ein Kontakt (K) mindestens das Kontaktloch füllt und das zweite Source-/Drain-Gebiet (TS2) des Transfertransistors (T) überlappt.

**8.** Verfahren zum Betrieb einer DRAM-Zellenanordnung nach einem der Ansprüche 1 bis 7,

- bei dem zum Schreiben von Information auf die Speicherzelle die Wortleitung (W) mit einer solchen Schreibspannung beaufschlagt wird, daß der Transfertransistor (T) leitet,
- bei dem beim Schreiben der Information die Bitleitung (B) mit einer Bitleitungsspannung beaufschlagt wird, die abhängig von der zu speichernden Information ist, so daß die Floating-Gateelektrode mit einer von der Bitleitungsspannung abhängigen Ladung geladen wird,
- bei dem zum Auslesen der Information der Speicherzelle die Wortleitung (W) mit einer solchen Lesespannung beaufschlagt wird, daß abhängig von der Ladung auf der Floating-Gateelektrode ein Signal an der Bitleitung (B) erzeugt wird,
- bei dem zwischen dem Schreiben und dem Auslesen der Information die Wortleitung (W) mit einer solchen Ruhespannung beaufschlagt wird, daß der Speichertransistor (S) und der Transfertransistor (T) sperren.

**9.** Verfahren nach Anspruch 8,

- bei dem die Schreibspannung derart ist, daß der Speichertransistor (S) sperrt.

**10.** Verfahren nach Anspruch 8 oder 9,

- bei dem die Lesespannung derart ist, daß der Transfertransistor (T) sperrt.

**11.** Verfahren nach Anspruch 9 oder 10,

- bei dem der Speichertransistor (S) von einem Leitfähigkeitstyp ist, der entgegengesetzt zu einem Leitfähigkeitstyp des Transfertransistors (T) ist.

**12.** Verfahren nach Anspruch 11,

- bei dem der Transfertransistor (T) ein p-Kanal-Transistor ist,
- bei dem die Schreibspannung gleich 0 Volt ist,
- bei dem die Bitleitungsspannung abhängig von der zu speichernden Information gleich der Betriebsspannung oder gleich 0 Volt ist,
- bei dem die Lesespannung gleich einer Betriebsspannung ist,
- bei dem die Ruhespannung größer als 0 Volt und kleiner als die Betriebsspannung ist.

**13.** Verfahren nach einem der Ansprüche 8 bis 12,

- bei dem die Bitleitungsspannung abhängig von der zu speichernden Information derart ist, daß der Speichertransistor (S) beim Auslesen einer logischen Eins als Information leitet und beim Auslesen einer logischen Null als Information sperrt oder umgekehrt.

**14.** Verfahren zur Erzeugung einer DRAM-Zellenanordnung nach einem der Ansprüche 1 bis 7,

- bei dem mehrere Speicherzellen erzeugt werden,
- bei dem für die Speicherzellen jeweils ein Speichertransistor (S) und ein Transfertransistor (T) erzeugt werden,
- bei dem in einem Substrat (1) ein erstes Source-/Drain-Gebiet (SS1), ein Kanalgebiet und ein zweites Source-/Drain-Gebiet (SS2) des Speichertransistors (S) nebeneinander und angrenzend an eine Oberfläche des Substrats (1) erzeugt werden,
- bei dem auf dem Substrat (1) eine isolierende Schicht (I) erzeugt wird, in der eine Vertiefung (V) erzeugt wird, die bis zum Kanalgebiet des Speichertransistors (S) reicht,
- bei dem mindestens auf einem Boden der Vertiefung (V) ein erstes Dielektrikum (D1) erzeugt wird,
- bei dem eine Schicht aus von einem ersten Leitfähigkeitstyp dotiertem Polysilizium (P) auf der isolierenden Schicht (I) so erzeugt wird, daß sie Flanken der Vertiefung (V) und das erste Dielektrikum (D1) am Boden der Vertiefung (V) bedeckt, ohne die Vertiefung (V) aufzufüllen,
- bei dem eine Implantation im wesentlichen senkrecht zur Oberfläche des Substrats (1) so durchgeführt wird, daß aus der Schicht aus Polysilizium (P) ein von einem zweiten, zum ersten Leitfähigkeitstyp entgegengesetzten Leitfähigkeitstyp dotiertes erstes Source-/Drain-Gebiet (TS1) des Transfertransistors (T) erzeugt wird, das auf dem ersten Dielektrikum (D1) am Boden der Vertiefung (V) angeordnet ist, und daß aus der Schicht aus Polysilizium (P) ein vom zweiten Leitfähigkeitstyp dotiertes zweites Source-/Drain-Gebiet (TS2) des Transfertransistor (T) erzeugt wird, das auf der isolierenden Schicht (I) angeordnet ist, und daß aus der Schicht aus Polysilizium (P) ein vom ersten Leitfähigkeitstyp dotiertes Kanalgebiet des Transfertransistors (T) erzeugt wird, das an den Flanken der Vertiefung (V) angeordnet ist,
- bei dem ein zweites Dielektrikum (D2) auf der Schicht aus Polysilizium (P) erzeugt wird,
- bei dem eine Kontroll-Gateelektrode (KG) des Speichertransistors (S) auf dem zweiten Dielektrikum (D2) erzeugt wird.

**15.** Verfahren nach Anspruch 14,

- bei dem das erste Source-/Drain-Gebiet (SS1) und das zweite Source-/Drain-Gebiet (SS2) des Speichertransistors (S) so erzeugt werden, daß sie vom ersten Leitfähigkeitstyp dotiert sind,
- bei dem das Kanalgebiet des Speichertransistors (S) so erzeugt wird, daß es vom zweiten Leitfähigkeitstyp dotiert ist.

**16.** Verfahren nach Anspruch 14 oder 15,

- bei dem auf der Oberfläche des Substrats (1) eine Maske (M) erzeugt wird, die mindestens das Kanalgebiet des Speichertransistors (S) bedeckt,
- bei dem mit Hilfe der Maske (M) eine Implantation durchgeführt wird, so daß das erste Source-/Drain-Gebiet (SS1) und das zweite Source-/Drain-Gebiet (SS2) des Speichertransistors (S) erzeugt werden,
- bei dem angrenzend an die Maske (M) Spacer (SP) gebildet werden,
- bei dem zur Erzeugung der isolierenden Schicht (I) isolierendes Material abgeschieden und abgetragen wird, bis die Maske (M) und die Spacer (SP) teilweise freigelegt wird,
- bei dem durch Entfernung der Maske (M) und der Spacer (SP) die Vertiefung (V) erzeugt wird.

**17.** Verfahren nach einem der Ansprüche 14 bis 16,

- bei dem die Schicht aus Polysilizium (P) so strukturiert wird, daß sie auf der isolierenden Schicht (I) eine für die Kontaktierung des zweiten Source-/Drain-Gebiets (TS2) des Transfertransistors (T) geeignete Ausdehnung aufweist,
- bei dem nach Erzeugung der Kontroll-Gateelektrode (KG) ein Zwischenoxid (Z) aufgebracht wird,
- bei dem durch maskiertes Ätzen des Zwischenoxids (Z) und der isolierenden Schicht (I) selektiv zur Schicht aus Polysilizium (P) ein Kontaktloch derart erzeugt wird, daß ein erster Teil des Kontaktlochs bis zum zweiten Source-/Drain-Gebiet (SS2) des Speichertransistors (S) reicht und ein zweiter Teil des Kontaktlochs bis zur Schicht aus Polysilizium (P) reicht, - bei dem das Kontaktloch mit einem Kontakt (K) gefüllt wird.

# FIG 1

# FIG 2

X →

## FIG 3

## FIG 4

## FIG 5